# EUROPEAN PATENT APPLICATION

(11) **EP 4 492 467 A1**
(43) Date of publication of application: **15.01.2025**
(21) Application number: 22930985.1
(22) Date of filing: 28.09.2022
(51) Int. Cl.: H01L 27/146

(54) **LIGHT DETECTION DEVICE, ELECTRONIC APPARATUS, AND LIGHT DETECTION SYSTEM**

(30) Priority: 09.03.2022 US 202263318117 P
(71) Applicant: Sony Semiconductor Solutions Corporation, Atsugi-shi, Kanagawa 243-0014 (JP)
(72) Inventor: OGINO, Takumi, Atsugi-shi, Kanagawa 243-0014 (JP); SHIINA, Kimiyasu, Atsugi-shi, Kanagawa 243-0014 (JP); YOSHIDA, Shinichi, Atsugi-shi, Kanagawa 243-0014 (JP); EBIKO, Yoshiki, Atsugi-shi, Kanagawa 243-0014 (JP)
(74) Representative: Müller Hoffmann & Partner
(86) International application number: PCT/JP2022/036209
(87) International publication number: WO 2023/171008

(57) **Abstract**

An optical detection unit according to one embodiment of the present disclosure includes: a first photoelectric converter that photoelectrically converts a wavelength component in a visible light region; a second photoelectric converter that photoelectrically converts a wavelength component in a near-infrared region, the second photoelectric converter being stacked on the first photoelectric converter; and a first wiring layer provided between the first photoelectric converter and the second photoelectric converter, the first wiring layer including one or a plurality of wirings formed with use of a material that transmits a wavelength component in a longer wavelength region than the visible light region, the one or the plurality of wirings being used for reading out charges generated through photoelectric conversion in the first photoelectric converter.

## Description

### Technical Field

The present disclosure relates to an optical detection unit in which, for example, photoelectric conversion devices are stacked with a wiring layer interposed therebetween, and to an electronic apparatus and an optical detection system.

### Background Art

For example, PTL 1 discloses an imaging device in which photoelectric conversion devices are stacked with a wiring layer interposed therebetween.

### Citation List

### Patent Literature

PTL 1: Japanese Unexamined Patent Application Publication No. 2013-70030

### Summary of the Invention

Incidentally, in the optical detection unit in which the photoelectric conversion devices are stacked with the wiring layer interposed therebetween as described above, improvement of an image quality is desired.

It is desirable to provide an optical detection unit, an electronic apparatus, and an optical detection system that each make it possible to improve an image quality in each of a visible light region and a near-infrared region.

An optical detection unit serving as one embodiment of the present disclosure includes: a first photoelectric converter that photoelectrically converts a wavelength component in a visible light region; a second photoelectric converter that photoelectrically converts a wavelength component in a near-infrared region, the second photoelectric converter being stacked on the first photoelectric converter; and a first wiring layer provided between the first photoelectric converter and the second photoelectric converter, the first wiring layer including one or a plurality of wirings formed with use of a material that transmits a wavelength component in a longer wavelength region than the visible light region, the one or the plurality of wirings being used for reading out charges generated through photoelectric conversion in the first photoelectric converter.

An electronic apparatus serving as one embodiment of the present disclosure includes the above-described optical detection unit according to the one embodiment of the present disclosure.

An optical detection system serving as one embodiment of the present disclosure includes a light source that emits near-infrared light and an optical detection unit that detects ambient light and the near-infrared light that are reflected by an object, and the optical detection system includes, as the optical detection unit, the above-described optical detection unit according to the one embodiment of the present disclosure.

In the optical detection unit serving as one embodiment of the present disclosure, the electronic apparatus serving as one embodiment of the present disclosure, and the optical detection system serving as one embodiment of the present disclosure, the first photoelectric converter photoelectrically converts a wavelength component in the visible light region, the second photoelectric converter photoelectrically converts a wavelength component in the near-infrared region, and the one or the plurality of wirings included in the first wiring layer provided between the first photoelectric converter and the second photoelectric converter that are stacked on each other is formed with use of a material that transmits a wavelength component in a longer wavelength region than the visible light region. This configuration reduces reduction of incident light entering the second photoelectric converter.

### Brief Description of Drawing

[FIG. 1] FIG. 1 is a schematic cross-sectional view illustrating an example of a configuration of an optical detection unit according to an embodiment of the present disclosure.
[FIG. 2] FIG. 2 is a schematic plan view illustrating an example of the configuration of the optical detection unit illustrated in FIG. 1.
[FIG. 3A] FIG. 3Ais a schematic cross-sectional view describing an example of a method of manufacturing the optical detection unit illustrated in FIG. 1.
[FIG. 3B] FIG. 3B is a schematic cross-sectional view illustrating a step subsequent to FIG. 3A.
[FIG. 3C] FIG. 3C is a schematic cross-sectional view illustrating a step subsequent to FIG. 3B.
[FIG. 4A] FIG. 4A is a schematic cross-sectional view describing another example of the method of manufacturing the optical detection unit illustrated in FIG. 1.
[FIG. 4B] FIG. 4B is a schematic cross-sectional view illustrating a step subsequent to FIG. 4A.
[FIG. 4C] FIG. 4C is a schematic cross-sectional view illustrating a step subsequent to FIG. 4B.
[FIG. 4D] FIG. 4D is a schematic cross-sectional view illustrating a step subsequent to FIG. 4C.
[FIG. 5] FIG. 5 is a schematic cross-sectional view illustrating an example of a configuration of an optical detection unit according to Modification Example 1 of the present disclosure.
[FIG. 6] FIG. 6 is a schematic cross-sectional view illustrating an example of a configuration of an optical detection unit according to Modification Example 2 of the present disclosure.
[FIG. 7A] FIG. 7Ais a schematic cross-sectional view describing an example of a method of manufacturing the optical detection unit illustrated in FIG. 6.
[FIG. 7B] FIG. 7B is a schematic cross-sectional view illustrating a step subsequent to FIG. 7A.
[FIG. 7C] FIG. 7C is a schematic cross-sectional view illustrating a step subsequent to FIG. 7B.
[FIG. 8] FIG. 8 is a schematic cross-sectional view illustrating an example of a configuration of an optical detection unit according to Modification Example 3 of the present disclosure.
[FIG. 9A] FIG. 9A is a schematic cross-sectional view describing an example of a method of manufacturing the optical detection unit illustrated in FIG. 8.
[FIG. 9B] FIG. 9B is a schematic cross-sectional view illustrating a step subsequent to FIG. 9A.
[FIG. 9C] FIG. 9C is a schematic cross-sectional view illustrating a step subsequent to FIG. 9B.
[FIG. 9D] FIG. 9D is a schematic cross-sectional view illustrating a step subsequent to FIG. 9C.
[FIG. 9E] FIG. 9E is a schematic cross-sectional view illustrating a step subsequent to FIG. 9D.
[FIG. 9F] FIG. 9F is a schematic cross-sectional view illustrating a step subsequent to FIG. 9E.
[FIG. 10A] FIG. 10A is a schematic cross-sectional view describing another example of the method of manufacturing the optical detection unit illustrated in FIG. 8.
[FIG. 10B] FIG. 10B is a schematic cross-sectional view illustrating a step subsequent to FIG. 10A.
[FIG. 10C] FIG. 10C is a schematic cross-sectional view illustrating a step subsequent to FIG. 10B.
[FIG. 10D] FIG. 10D is a schematic cross-sectional view illustrating a step subsequent to FIG. 10C.
[FIG. 10E] FIG. 10E is a schematic cross-sectional view illustrating a step subsequent to FIG. 10D.
[FIG. 10F] FIG. 10F is a schematic cross-sectional view illustrating a step subsequent to FIG. 10E.
[FIG. 10G] FIG. 10G is a schematic cross-sectional view illustrating a step subsequent to FIG. 10F.
[FIG. 11] FIG. 11 is a block diagram illustrating an overall configuration of the optical detection unit illustrated in FIG. 1 or other figures.
[FIG. 12] FIG. 12 is a block diagram illustrating an example of a configuration of an electronic apparatus using the optical detection unit illustrated in FIG. 23.
[FIG. 13A] FIG. 13A is a schematic diagram illustrating an example of an overall configuration of an optical detection system using the optical detection unit illustrated in FIG. 23.
[FIG. 13B] FIG. 13B is a diagram illustrating an example of a circuit configuration of the optical detection system illustrated in FIG. 23.
[FIG. 14] FIG. 14 is a view depicting an example of a schematic configuration of an endoscopic surgery system.
[FIG. 15] FIG. 15 is a block diagram depicting an example of a functional configuration of a camera head and a camera control unit (CCU).
[FIG. 16] FIG. 16 is a block diagram depicting an example of schematic configuration of a vehicle control system.
[FIG. 17] FIG. 17 is a diagram of assistance in explaining an example of installation positions of an outside-vehicle information detecting section and an imaging section.

### Modes for Carrying Out the Invention

In the following, some embodiments of the present disclosure will be described in detail with reference to the drawings. The following description is one specific example of the present disclosure, and the present disclosure is not limited to the following embodiments. In addition, the arrangement, dimensions, dimension ratios, and the like of components illustrated in each drawing in the present disclosure are also not limited to those embodiments. It is to be noted that the description will be given in the following order.
1. Embodiment (example in which a wiring in a wiring layer between stacked light receivers is formed with use of polysilicon)
   1-1. Configuration of Optical Detection Unit
   1-2. Method of Manufacturing Optical Detection Unit
   1-3. Actions and Effects
2. Modification Examples
   2-1. Modification Example 1 (example in which a band-pass filter is disposed between stacked light receivers)
   2-2. Modification Example 2 (example in which a readout circuit and a logic circuit are provided on different substrates and stacked)
   2-3. Modification Example 3 (example in which a light receiver for near-infrared light is formed of black silicon)
3. Application Examples
4. Usage Examples

### <1. Embodiment>

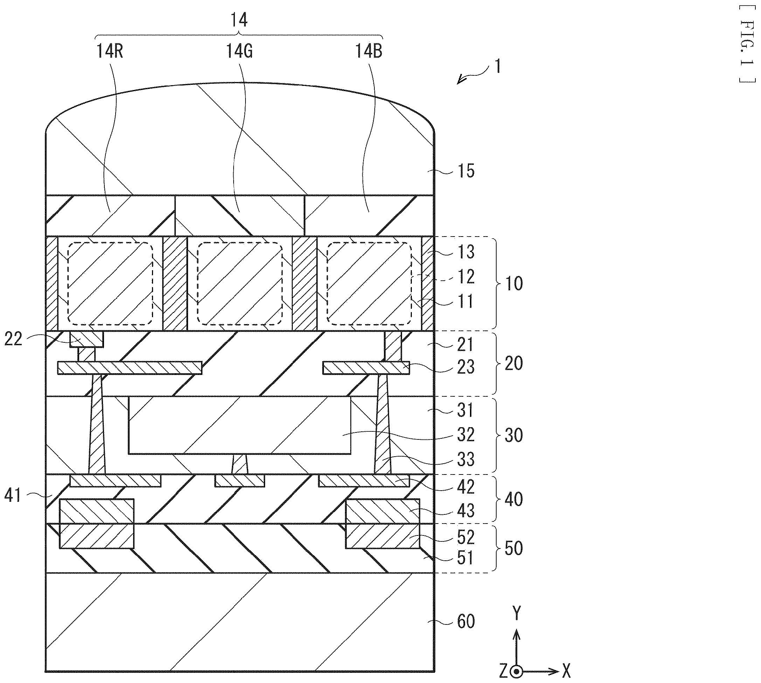

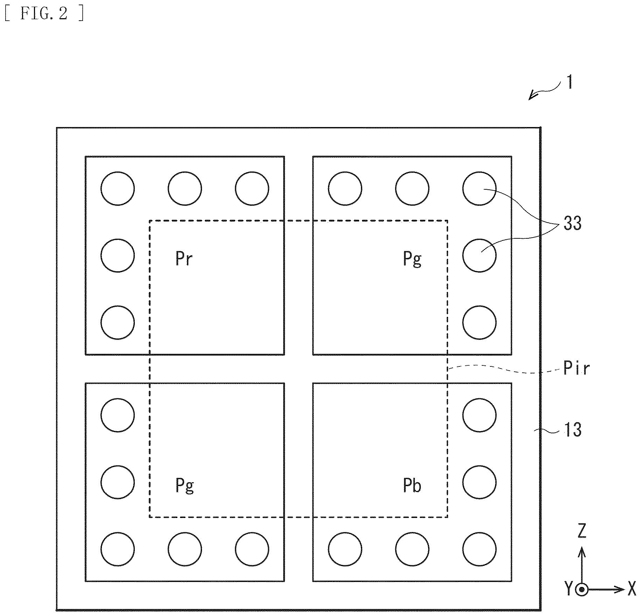

FIG. 1 schematically illustrates an example of a cross-sectional configuration of an optical detection unit (optical detection unit 1) according to one embodiment of the present disclosure. FIG. 2 schematically illustrates an example of a planar configuration of the optical detection unit 1 illustrated in FIG. 1. The optical detection unit 1 is used in, for example, a CMOS (Complementary Metal Oxide Semiconductor) image sensor or a distance image sensor that measures a distance by a ToF (Time-of-Flight) method. The CMOS image sensor or the distance image sensor is used in an electronic apparatus such as a digital still camera or a video camera.

The optical detection unit 1 includes a light receiver 10 and a light receiver 30 that are stacked in the stated order from a light incident side with a wiring layer 20 interposed therebetween. The light receiver 10 includes a photoelectric converter 12 that photoelectrically converts a wavelength component in a visible light region. The light receiver 30 includes a photoelectric converter 32 that photoelectrically converts a wavelength component in a near-infrared region. In the optical detection unit 1 of this embodiment, one or a plurality of wirings formed in the wiring layer 20 is formed with use of a material (for example, polysilicon (Poly-Si)) that transmits a wavelength component in a longer wavelength region than the visible light region.

### [1-1. Configuration of Optical Detection Unit]

The optical detection unit 1 includes the light receiver 10, the wiring layer 20, the light receiver 30, a wiring layer 40, a wiring layer 50, and a circuit board 60 that are stacked in the stated order from the light incident side. In this embodiment, in the light receiver 10, the photoelectric converter 12 that photoelectrically converts a wavelength component in a visible light region is formed in a silicon substrate 11, and, in the light receiver 30, the photoelectric converter 32 that photoelectrically converts a wavelength component in a near-infrared region is embedded and formed in a silicon substrate 31. In the wiring layer 20, one or a plurality of wirings (for example, a gate wiring 22 and a wiring 23) is provided, and the one or the plurality of wirings (for example, the gate wiring 22 and the wiring 23) is formed with use of a material (for example, polysilicon (Poly-Si)) that transmits a wavelength component in a longer wavelength region than the visible light region. A color filter 14 and an on-chip lens 15 are disposed on the light incident side of the light receiver 10.

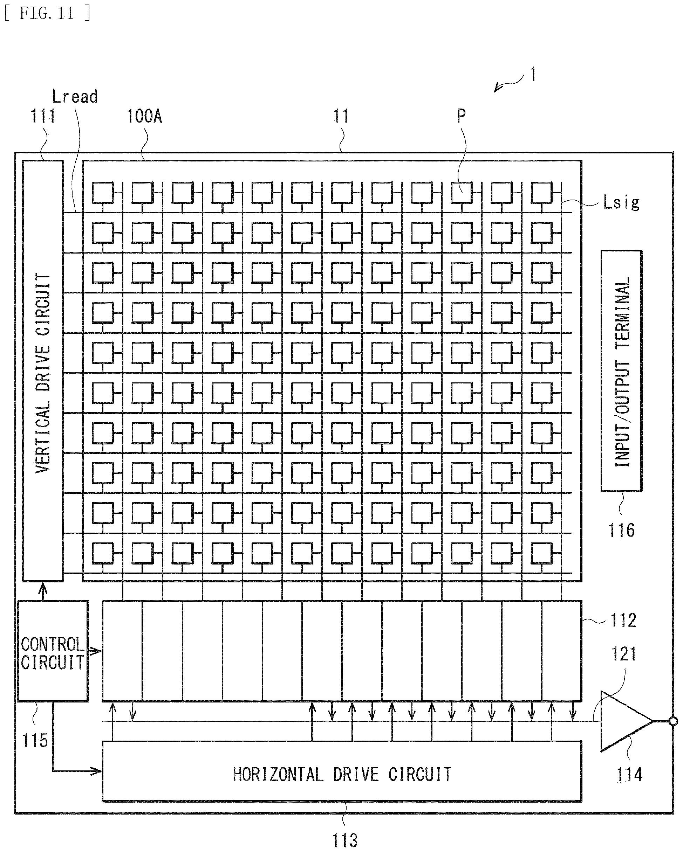

The light receiver 10 includes, in the silicon substrate 11, the photoelectric converter 12 that photoelectrically converts a wavelength component in the visible light region. The photoelectric converter 12 is formed for each unit pixel P (see FIG. 11). The photoelectric converter 12 corresponds to one specific example of a "first photoelectric converter" of the present disclosure. The photoelectric converter 12 is, for example, a PIN (Positive Intrinsic Negative) type photodiode PD, and has a pn junction in a predetermined region of the silicon substrate 11. The silicon substrate 11 has a first surface 11S1 serving as a light incident surface and a second surface 11 S2 on a side opposite to the first surface 11S1.

The silicon substrate 11 has an isolator 13 provided between adjacent unit pixels P. Specifically, for example, the isolator 13 is provided in a grid shape to surround each unit pixel P in a pixel section 100A including a plurality of unit pixels P disposed in an array pattern in row and column directions. The isolator 13 is provided for electrical isolation between adjacent unit pixels P. The isolator 13 has, for example, an FTI (Full Trench Isolation) structure that passes between the first surface 11S1 and the second surface 11S2 of the silicon substrate 11. As another example, the isolator 13 may have, for example, a DTI (Deep Trench Isolation) structure or a STI (Shallow Trench Isolation) structure that extends from one surface (for example, the first surface 11S1) of the silicon substrate 11 toward another surface (for example, the second surface 11S2) thereof to have a bottom portion in the silicon substrate 11.

The isolator 13 includes, for example, an insulating film such as a silicon oxide (SiOₓ) film. As another example, the isolator 13 may have a light blocking film embedded in the insulating film. This makes it possible to electrically and optically isolate the adjacent unit pixels P from each other.

In the second surface 11S2 of the silicon substrate 11, although not illustrated, a floating diffusion FD and a transfer transistor TR that outputs signal charges output from each unit pixel P to a readout circuit are provided.

On the first surface 11S1 side of the silicon substrate 11, the color filter 14 (14R, 14G, or 14B) that selectively transmits red light (R) of, for example, 570 nm or more and 700 nm or less, green light (G) of, for example, 460 nm or more and 600 nm or less, and blue light (B) of, for example, 400 nm or more and 520 nm or less is provided for each unit pixel P. Specifically, for example, as illustrated in FIG. 2, as four unit pixels P disposed in 2 rows×2 columns, two green pixels Pg are disposed on a diagonal line, and a red pixel Pr and a blue pixel Pb are disposed on another diagonal line orthogonal thereto. The color filters 14R, 14G, and 14B are respectively disposed in corresponding color pixels Pr, Pg, and Pb. Thus, color light corresponding to each color pixel Pr, Pg, or Pb is photoelectrically converted. That is, in the pixel section 100A, the unit pixels P (red pixel Pr, green pixel Pg, and blue pixel Pb) that respectively photoelectrically convert red light (R), green light (G), and blue light (B) are disposed in a Bayer layout.

The on-chip lens 15 is provided on the color filter 14. The on-chip lens 15 condenses light entering the on-chip lens 15 from above to the photoelectric converters 12 and 32, and is formed with use of, for example, silicon oxide (SiOₓ). For example, the on-chip lens 15 may be provided for each unit pixel P, or one on-chip lens 15 may be provided for every plurality of unit pixels P (for example, as described above, for every four unit pixels P disposed in 2 rows×2 columns).

The wiring layer 20 is provided on the second surface 11S2 side of the silicon substrate 11. In the wiring layer 20, one or a plurality of wirings is provided in an interlayer insulating layer 21. Examples of the one or the plurality of wirings include the gate wiring 22 such as a gate of the above-described transfer transistor TR, and the wiring 23 for use in supplying a voltage to be applied to the silicon substrate 11 or the photoelectric converter 12 and extracting charges generated in the photoelectric converter 12.

The gate wiring 22, the wiring 23, and other wirings formed in the interlayer insulating layer 21 are formed with use of a material that transmits a wavelength component in a longer wavelength region than the visible light region, including a via that electrically couples the wirings to each other. Examples of such a material include polysilicon (Poly-Si). The gate wiring 22, the wiring 23, and other wirings formed in the interlayer insulating layer 21 are, for example, electrically coupled to the circuit board 60 to be described later via a plurality of through wirings 33 that passes through the light receiver 30.

The light receiver 30 includes, for example, the photoelectric converter 32 provided in a semiconductor substrate embedded and formed in the silicon substrate 31. The photoelectric converter 32 corresponds to one specific example of a "second photoelectric converter" of the present disclosure. The semiconductor substrate corresponds to one specific example of a "semiconductor substrate" of the present disclosure, and is, for example, a Ge substrate containing germanium (Ge), a compound semiconductor substrate of silicon (Si) and Ge (for example, a SiGe substrate), or an InGaAs substrate containing indium (In), gallium (Ga), and arsenic (As). The semiconductor substrate has a third surface 32S1 disposed to be opposed to the second surface 11S2 of the silicon substrate 11 and a fourth surface 32S2 on a side opposite to the third surface 32S1.

The photoelectric converter 32 has its center disposed to substantially match, in plan view, for example, as illustrated in FIG. 2, an intersection of the four photoelectric converters 12 disposed in 2 rows×2 columns. That is, for example, one IR pixel Pir that photoelectrically converts a wavelength component in a near-infrared region of 1,100 nm or more is disposed for every four color pixels disposed in 2 rows×2 columns (one red pixel Pr, one blue pixel Pb, and two green pixels Pg). It is to be noted that the layout of the IR pixel Pir is not limited thereto, and, for example, one IR pixel Pir may be disposed for every sixteen color pixels disposed in 4 rows×4 columns.

In the light receiver 30, the plurality of through wirings 33 that electrically couples the circuit board 60 and the gate wiring 22, the wiring 23, and other wirings provided in the wiring layer 20 to each other passes through the light receiver 30. The through wiring 33 is formed with use of, for example, a metal material such as aluminum (Al), copper (Cu), or tungsten (W). The plurality of through wirings 33 is, for example, provided at four corners of the photoelectric converter 32, or, for example, as illustrated in FIG. 2, provided to surround the photoelectric converter 32. This makes it possible to reduce entry of oblique incident light from an adjacent pixel.

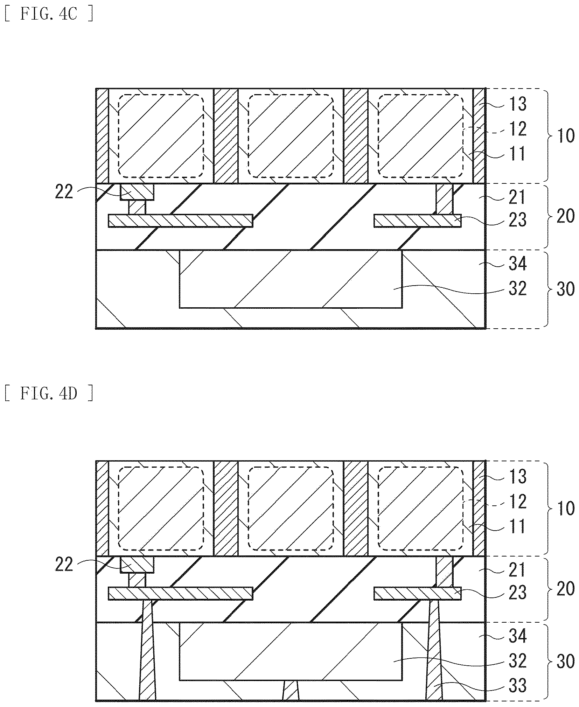

It is possible to form the semiconductor substrate configuring the photoelectric converter 32 by, for example, providing an opening to have a predetermined depth in the silicon substrate 31 and growing a semiconductor layer in the opening by using an epitaxial crystal growth method. It is to be noted that the photoelectric converter 32 may be embedded and formed in, instead of the silicon substrate 31, for example, an insulating film 34 (for example, see FIG. 4C). As another example, the silicon substrate 31 may be left only in a portion facing the fourth surface 32S2 of the photoelectric converter 32, and the peripheries of the photoelectric converter 32 and the silicon substrate 31 may be embedded with the insulating film 34. The insulating film 34 includes, for example, a single layer film including one type among silicon oxide (SiOₓ), TEOS, silicon nitride (SiNₓ), and silicon oxynitride (SiOₓN_{y}) or a multilayer film including two or more types of those materials.

The wiring layer 40 is provided on the fourth surface 32S2 side of the photoelectric converter 32. In the wiring layer 40, one or a plurality of wirings is provided in an interlayer insulating layer 41. Examples of the one or a plurality of wirings include the through wiring 33 and a wiring 42 for use in supplying a voltage to be applied to the photoelectric converter 32 and extracting charges generated in the photoelectric converter 32. The wiring 42 is formed with use of, similarly to the through wiring 33, for example, a metal material such as aluminum (Al), copper (Cu), or tungsten (W). One or a plurality of pad portions 43 is further embedded in the interlayer insulating layer 41, and is exposed to the surface of the interlayer insulating layer 41. The one or the plurality of pad portions 43 is formed with use of, for example, copper (Cu).

The circuit board 60 having the wiring layer 50 provided thereon is further disposed on the fourth surface 32S2 side of the photoelectric converter 32. The circuit board 60 corresponds to one specific example of a "circuit board" of the present disclosure. The circuit board 60 has a readout circuit, a logic circuit, and other circuits provided thereon. The readout circuit includes, for example, a reset transistor, an amplification transistor, and a selection transistor, and generates a pixel signal on the basis of signal charges generated through photoelectric conversion in each photoelectric converter 12 and each photoelectric converter 32. The logic circuit processes the pixel signal output from the readout circuit. One or a plurality of pad portions 52 is further embedded in an interlayer insulating layer 51, and is exposed to the surface of the interlayer insulating layer 51. The one or the plurality of pad portions 52 is formed with use of, for example, copper (Cu).

In the optical detection unit 1, for example, Cu-Cu bonding is established between the one or the plurality of pad portions 43 exposed to the surface of the wiring layer 40 and the one or the plurality of pad portions 52 exposed to the surface of the wiring layer 50. This allows the light receiver 10 and the light receiver 30 to be electrically coupled to the circuit board 60.

### [1-2. Method of Manufacturing Optical Detection Unit]

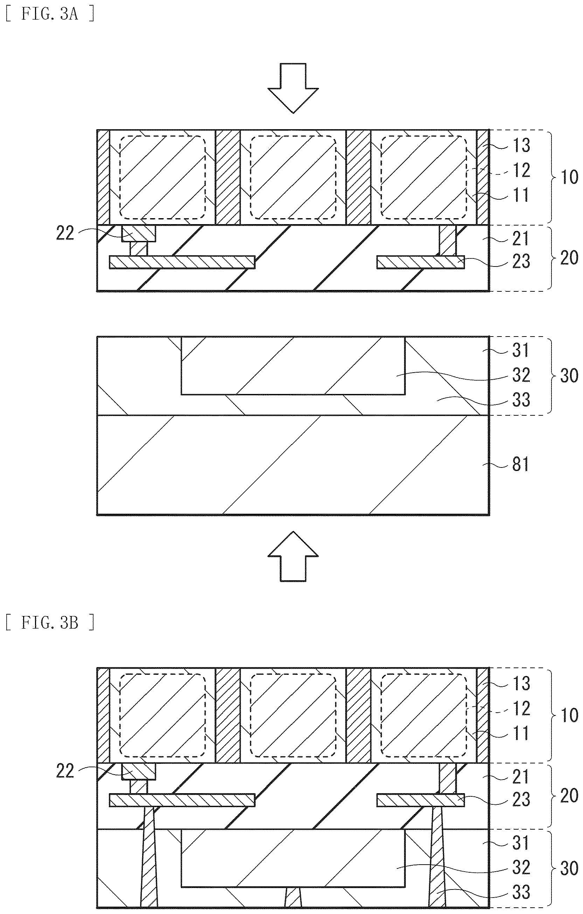

For example, it is possible to manufacture the optical detection unit 1 as follows. FIG. 3A to FIG. 3C illustrate an example of a method of manufacturing the optical detection unit 1 in order of process.

First, the light receiver 10 in which the photoelectric converter 12 and the isolator 13 are formed in the silicon substrate 11 is formed. After that, the wiring layer 20 including wirings (gate wiring 22 and wiring 23) formed with use of polysilicon is provided on the second surface 11S2 side of the silicon substrate 11. Further, the silicon substrate 31 is bonded to a support substrate 81, and an opening having a predetermined depth is formed in the silicon substrate 31. After that, a semiconductor layer including, for example, germanium (Ge) is formed in the opening by, for example, an epitaxial crystal growth method such as a Metal Organic Chemical Vapor Deposition (MOCVD) method. After that, for example, ion implantation is performed to control p-type or n-type impurity concentration to obtain the photoelectric converter 32. Thus, the light receiver 30 is formed. Those are, for example, as illustrated in FIG. 3A, bonded to each other with the wiring layer 20 and the light receiver 30 being disposed to face each other.

Next, as illustrated in FIG. 3B, the support substrate 81 is removed, and the silicon substrate 31 is thinned to a predetermined thickness. After that, the silicon substrate 31 is etched to form a through hole that reaches the wiring 23. After that, a metal material such as aluminum (Al) is embedded in the through hole by, for example, a CVD (Chemical Vapor Deposition) method, a PVD (Physical Vapor Deposition) method, an ALD (Atomic Layer Deposition) method, or a vapor deposition method, to thereby form the through wiring 33 and, for example, a contact via coupled to the photoelectric converter 32.

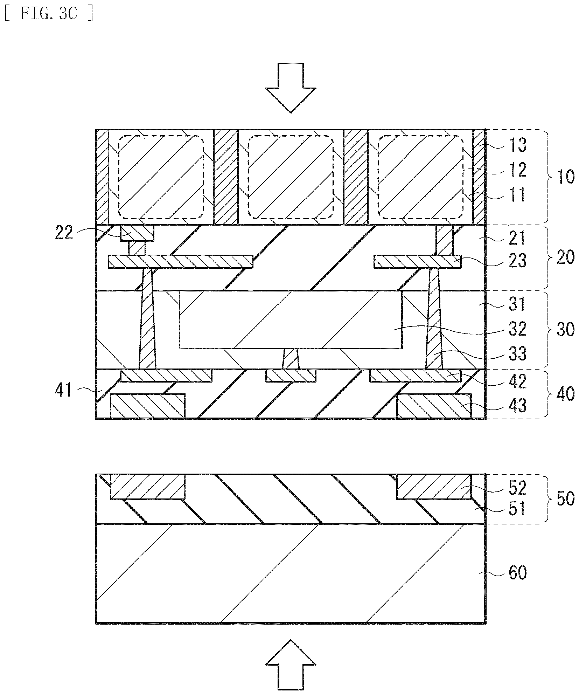

Subsequently, the surface of the silicon substrate 31 is flattened by, for example, CMP (Chemical Mechanical Polishing), and then the wiring layer 40 including the wiring 42 and the pad portion 43 is formed on the silicon substrate 31. Next, for example, as illustrated in FIG. 3C, the wiring layer 40 and the wiring layer 50 of the separately-formed circuit board 60 including the wiring layer 50 are disposed to face each other to allow the pad portions 43 and 52 to be joined and bonded to each other. After that, the color filter 14 and the on-chip lens 15 are formed in order on the first surface 11S1 side of the silicon substrate 11. In this manner, the optical detection unit 1 illustrated in FIG. 1 is completed.

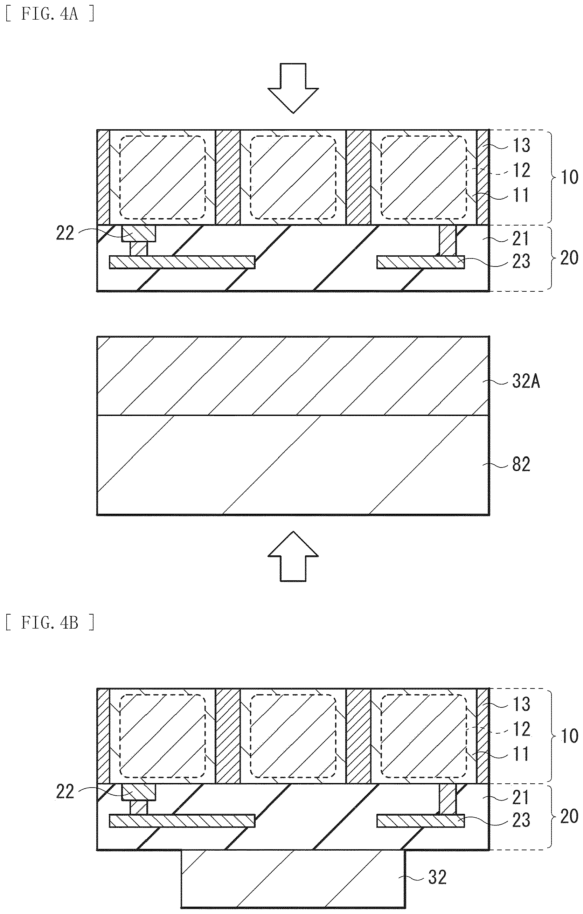

FIG. 4A to FIG. 4D illustrate another example of the method of manufacturing the optical detection unit 1 in order of process.

Similarly to the above-described manufacturing method, first, the light receiver 10 in which the photoelectric converter 12 and the isolator 13 are formed in the silicon substrate 11 is formed. After that, the wiring layer 20 including wirings (gate wiring 22 and wiring 23) formed with use of polysilicon is provided on the second surface 11S2 side of the silicon substrate 11. Further, on a silicon substrate 82, a semiconductor layer 32A including, for example, germanium (Ge) is formed by, for example, an epitaxial crystal growth method such as a MOCVD method. Those are, for example, as illustrated in FIG. 4A, bonded to each other with the wiring layer 20 and the semiconductor layer 32A being disposed to face each other.

Next, as illustrated in FIG. 4B, the silicon substrate 82 is removed, and the semiconductor layer 32A is processed by etching. After that, for example, ion implantation is performed to control p-type or n-type impurity concentration to form the photoelectric converter 32. Subsequently, as illustrated in FIG. 4C, the insulating film 34 is formed to embed the photoelectric converter 32 by using, for example, a CVD method.

Next, as illustrated in FIG. 4D, the insulating film 34 is etched to form a through hole that reaches the wiring 23. After that, a metal material such as aluminum (Al) is embedded in the through hole by, for example, a CVD method, a PVD method, an ALD method, or a vapor deposition method, to thereby form the through wiring 33 and, for example, a contact via coupled to the photoelectric converter 32. After that, similarly to the above-described manufacturing method, the surface of the insulating film 34 is flattened by, for example, CMP, and then the wiring layer 40 including the wiring 42 and the pad portion 43 is formed on the insulating film 34. Next, the wiring layer 40 and the wiring layer 50 of the separately-formed circuit board 60 including the wiring layer 50 are disposed to face each other to allow the pad portions 43 and 52 to be joined and bonded to each other. Finally, the color filter 14 and the on-chip lens 15 are formed in order on the first surface 11S1 side of the silicon substrate 11. In this manner, the optical detection unit 1 in which the photoelectric converter 32 is embedded in the insulating film 34 is completed.

### (1-3. Actions and Effects)

In the optical detection unit 1 of this embodiment, the light receiver 10 includes the photoelectric converter 12 that photoelectrically converts a wavelength component in the visible light region, the light receiver 30 includes the photoelectric converter 32 that photoelectrically converts a wavelength component in the near-infrared region, and the one or the plurality of wirings included in the wiring layer 20 provided between the light receiver 10 and the light receiver 30 that are stacked on each other is formed with use of a material that transmits a wavelength component in a longer wavelength region than the visible light region. This configuration reduces reduction of incident light entering the photoelectric converter 32. This is hereinafter described.

In recent years, in order to obtain various kinds of photoelectric conversion output, an optical detection unit (for example, a solid-state imaging device) including a plurality of stacked sensors has been proposed. However, in a general solid-state imaging device having a multilayer structure, as the number of pixels of an upper sensor closer to the light incident side is increased, a wiring density of a wiring layer formed below the upper sensor is increased, and thus a light incident amount to a sensor disposed on the lower side is reduced. This has a disadvantage in that the image quality of the lower sensor is degraded.

In contrast, in this embodiment, the light receiver 10 includes the photoelectric converter 12 that photoelectrically converts a wavelength component in the visible light region, the light receiver 30 includes the photoelectric converter 32 that photoelectrically converts a wavelength component in the near-infrared region, and, for example, the gate wiring 22 and the wiring 23 included in the wiring layer 20 provided between the light receiver 10 and the light receiver 30 that are stacked in order from the light incident side is formed with use of, for example, polysilicon that transmits a wavelength component in a longer wavelength region than the visible light region. This configuration reduces reduction of incident light entering the photoelectric converter 32 due to reflection or absorption by the gate wiring 22, the wiring 23, and a via that couples those wirings to each other.

As described above, in the optical detection unit 1 of this embodiment, it is possible to improve the image quality of the light receiver 30 (IR sensor) including the photoelectric converter 32 that photoelectrically converts a wavelength component in the near-infrared region. The light receiver 30 is disposed below the light receiver 10 (visible light sensor) including the photoelectric converter 12 that photoelectrically converts a wavelength component in the visible light region. Further, it is possible to obtain finer and a larger number of red pixels Pr, green pixels Pg, and blue pixels Pb provided in the light receiver 10, and it is thus possible to improve also the image quality of the light receiver 10 (visible light sensor).

Further, in this embodiment, the plurality of through wirings 33 that electrically couples the circuit board 60 and the gate wiring 22, the wiring 23, or other wirings to each other is provided around the IR pixel Pir (photoelectric converter 32 that photoelectrically converts a wavelength component of an infrared range). It is thus possible to reduce entry of oblique incident light from an adjacent pixel.

Next, Modification Examples 1 to 3 of the present disclosure are described. In the following, components similar to those of the above-described embodiment are denoted by the same reference symbols, and description thereof is omitted as appropriate.

### <2. Modification Examples>

### [2-1. Modification Example 1]

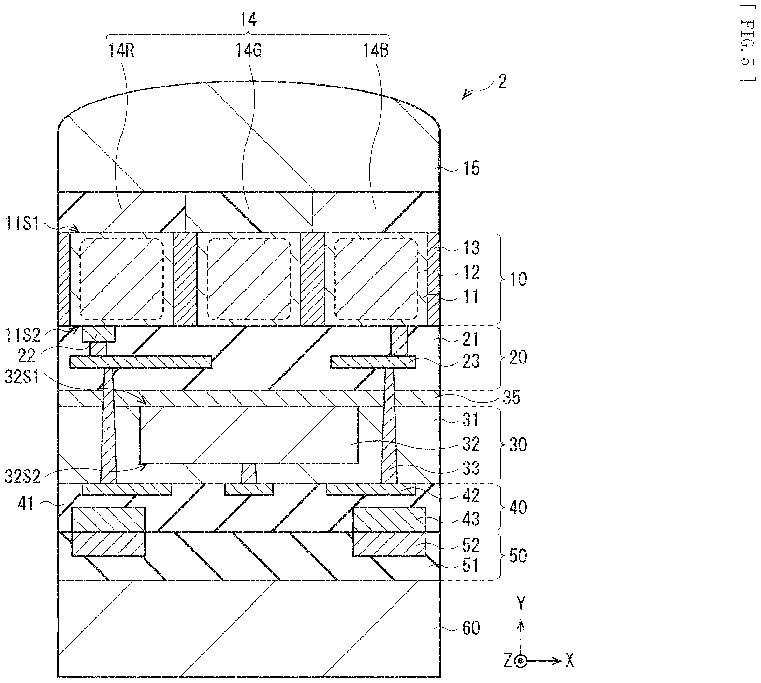

FIG. 5 schematically illustrates an example of a cross-sectional configuration of an optical detection unit (optical detection unit 2) according to Modification Example 1 of the present disclosure.

For example, a band-pass filter 35 having a transmission band in a near-infrared light range may be provided between the IR pixel Pir and the red pixel Pr, the green pixel Pg, and the blue pixel Pb. For example, it is possible to provide the band-pass filter 35 between the wiring layer 20 and the light receiver 30. This suppresses entry of, for example, visible light (for example, red light (R) on a long wavelength side) that has not sufficiently been absorbed in the photoelectric converter 12. That is, color mixture of visible light in the IR pixel Pir is reduced.

It is to be noted that, in place of the band-pass filter 35, the IR pixel Pir may be corrected in accordance with the output of the red pixel Pr. This makes it possible to prevent color mixture between adjacent pixels caused when visible light reflected in the band-pass filter 35 enters an adjacent pixel.

### [2-2. Modification Example 2]

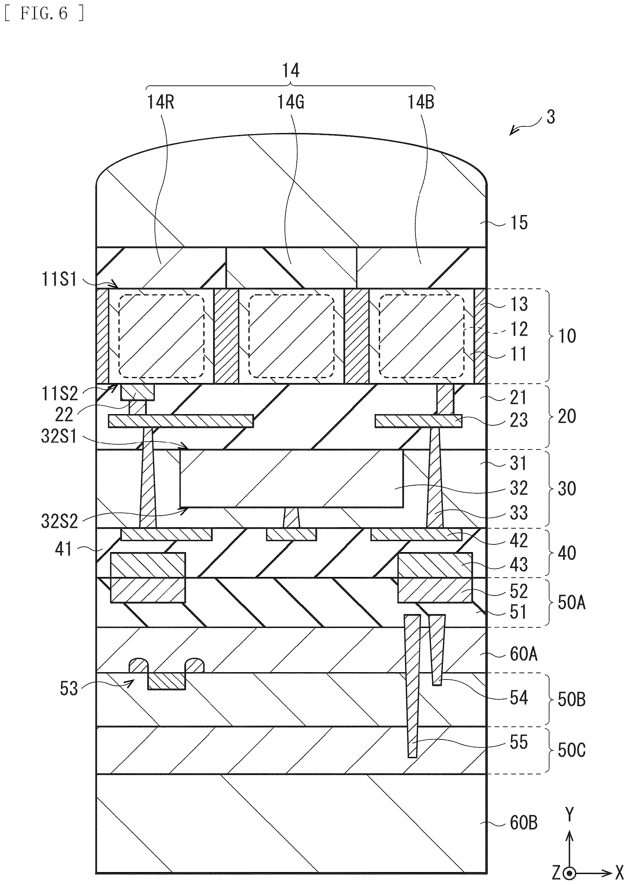

FIG. 6 schematically illustrates an example of a cross-sectional configuration of an optical detection unit (optical detection unit 3) according to Modification Example 2 of the present disclosure. The optical detection unit 3 of this modification example is different from the above-described embodiment in that the readout circuit and the logic circuit formed on the circuit board 60 are respectively formed on different substrates (Readout Integrated Circuit (ROIC) substrate 60A and logic substrate 60B), and those substrates are stacked on each other.

In the optical detection unit 3, the light receiver 10, the wiring layer 20, the light receiver 30, the wiring layer 40, a wiring layer 50A, the ROIC substrate 60A, a wiring layer 50B, a wiring layer 50C, and the logic substrate 60B are stacked in the stated order from the light incident side. In the light receiver 10, the photoelectric converter 12 that photoelectrically converts a wavelength component in the visible light region is embedded and formed in the silicon substrate 11, and, in the light receiver 30, the photoelectric converter 32 that photoelectrically converts a wavelength component in the near-infrared region is embedded and formed in the silicon substrate 31. In the wiring layer 20, one or a plurality of wirings (for example, the gate wiring 22 and the wiring 23) is provided, and the one or the plurality of wirings (for example, the gate wiring 22 and the wiring 23) is formed with use of a material (for example, polysilicon) that transmits a wavelength component in a longer wavelength region than the visible light region. The color filter 14 and the on-chip lens 15 are disposed on the light incident side of the light receiver 10.

The ROIC substrate 60A is disposed on the fourth surface 32S2 side of the photoelectric converter 32. A plurality of readout circuits 53 is provided on the ROIC substrate 60A. The plurality of readout circuits 53 generates a pixel signal on the basis of signal charges generated through photoelectric conversion in each photoelectric converter 12 and each photoelectric converter 32. Specifically, for example, the wiring layer 50A in which a pad portion 52 is exposed to the surface is provided on a surface side of the ROIC substrate 60A opposed to the wiring layer 40, and the wiring layer 50B in which the readout circuit 53 is formed is provided on a surface side on a side opposite to the surface opposed to the wiring layer 40.

The logic substrate 60B is disposed on the fourth surface 32S2 side of the photoelectric converter 32 with the ROIC substrate 60A interposed therebetween. A logic circuit or the like is provided on the logic substrate 60B, The logic circuit processes the pixel signal output from the readout circuit 53. Specifically, for example, the wiring layer 50C in which the logic circuit or the like is formed is provided on a surface side of the logic substrate 60B opposed to the wiring layer 50B.

The ROIC substrate 60A and the logic substrate 60B are each electrically coupled to the light receiver 10 side and the light receiver 30 side by through wirings 54 and 55 passing through the ROIC substrate 60A. The through wirings 54 and 55 are formed with use of, for example, a metal material such as aluminum (Al), copper (Cu), or tungsten (W).

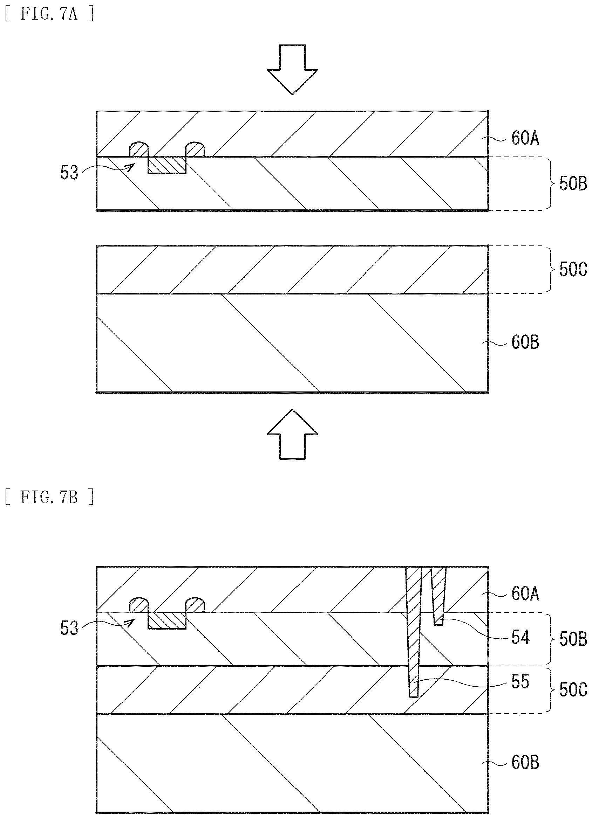

FIG. 7A to FIG. 7C illustrate an example of a method of manufacturing the optical detection unit 3 in order of process.

The light receiver 10, the wiring layer 20, the light receiver 30, and the wiring layer 40 are, for example, formed similarly to the above-described embodiment. It is possible to form the ROIC substrate 60A and the logic substrate 60B as follows, for example. First, the wiring layer 50B including the readout circuit 53 is formed on the ROIC substrate 60A, and the wiring layer 50C including the logic circuit or the like is formed on the logic substrate 60B. Then, as illustrated in FIG. 7A, the wiring layer 50B and the wiring layer 50C are disposed to face each other and are bonded to each other.

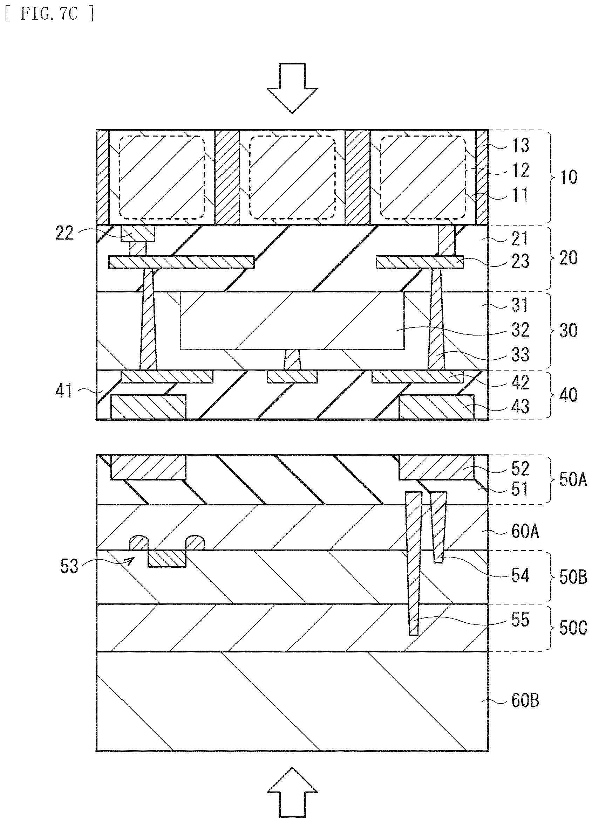

Next, as illustrated in FIG. 7B, the ROIC substrate 60A is thinned to a predetermined thickness by, for example, CMP. After that, the through wirings 54 and 55 that pass through the ROIC substrate 60A to respectively reach the wiring layers 50B and 50C are formed. Subsequently, as illustrated in FIG. 7C, the wiring layer 50A including the pad portion 52 is formed on the ROIC substrate 60A, and then the wiring layer 40 formed on the light receiver 30 formed in advance and the wiring layer 50A are disposed to face each other to allow the pad portions 43 and 52 to be joined and bonded to each other. After that, the color filter 14 and the on-chip lens 15 are formed in order on the first surface 11S1 side on the silicon substrate 11. In this manner, the optical detection unit 3 illustrated in FIG. 6 is completed.

As described above, in this modification example, the plurality of readout circuits that generates a pixel signal on the basis of signal charges generated through photoelectric conversion in each photoelectric converter 12 and each photoelectric converter 32 is formed on the ROIC substrate 60A, and, for example, the logic circuit that processes the pixel signal output from the readout circuit 53 is formed on the logic substrate 60B. Further, the ROIC substrate 60A and the logic substrate 60B are stacked on each other. This makes it possible to obtain further finer and a further larger number of red pixels Pr, green pixels Pg, and blue pixels Pb. It is thus possible to further improve the image quality in each of the visible light region and the near-infrared region.

### [2-3. Modification Example 3]

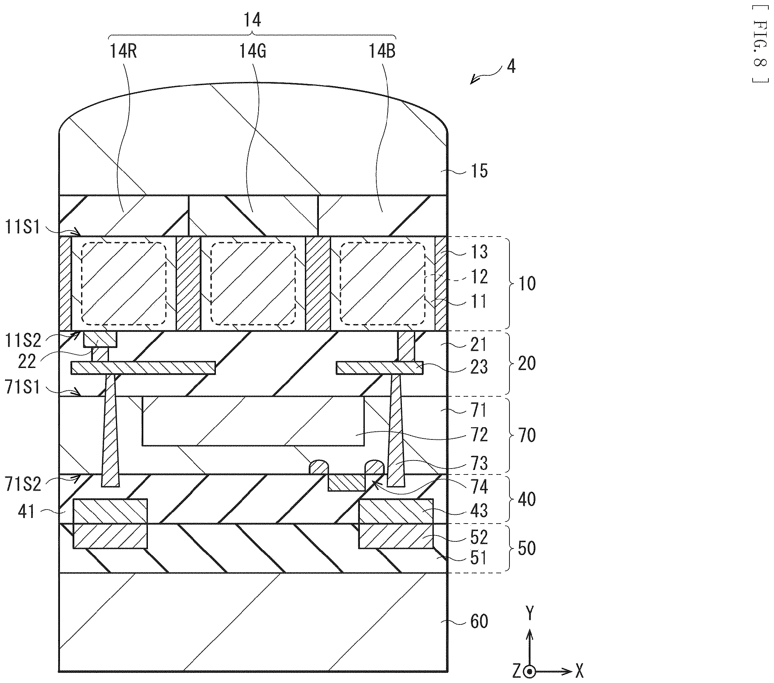

FIG. 8 schematically illustrates an example of a cross-sectional configuration of an optical detection unit (optical detection unit 4) according to Modification Example 3 of the present disclosure. The optical detection unit 4 of this modification example is different from the above-described embodiment in that a light receiver 70 is provided in place of the light receiver 30 of the above-described embodiment or others. In the light receiver 70, a photoelectric converter 72 that photoelectrically converts a wavelength component in the near-infrared region is formed in black silicon (Black-Si) embedded and formed in a silicon substrate 71.

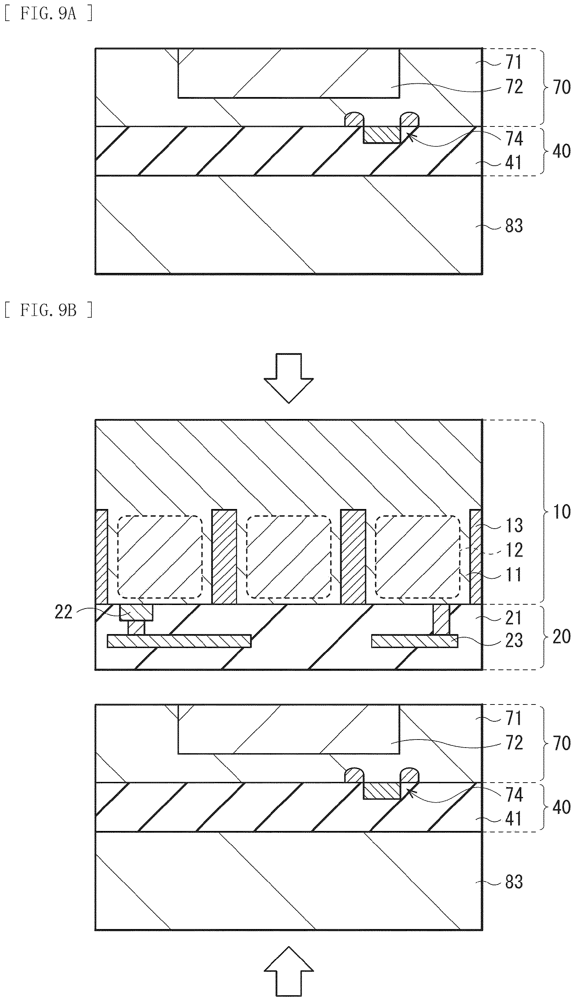

FIG. 9A to FIG. 9F illustrate an example of a method of manufacturing the optical detection unit 4 in order of process.

First, a pixel transistor 74 is formed on a surface 71S2 side of the silicon substrate 71 bonded onto a substrate (not illustrated). After that, the wiring layer 40 is further formed. Next, a support substrate 83 is bonded onto the wiring layer 40, and the substrate bonded to the silicon substrate 71 is removed. After that, the silicon substrate 71 is thinned to a predetermined thickness from a surface 71S1 side.

Subsequently, as illustrated in FIG. 9A, on the surface 71S1 side of the silicon substrate 71, for example, a black silicon region is formed by using dry etching or a laser, and this black silicon region is used as the photoelectric converter 72 to allow the light receiver 70 to be formed.

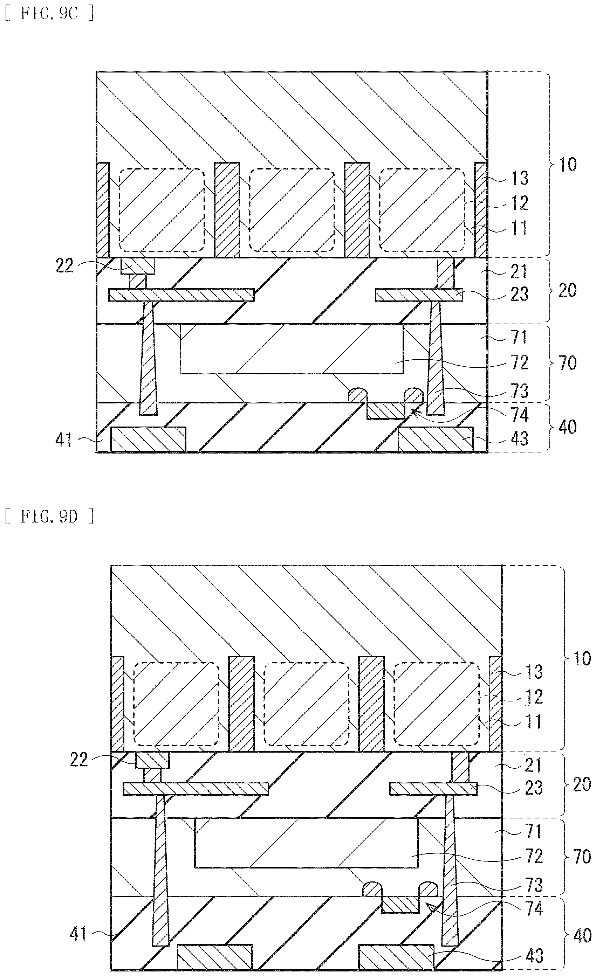

Next, as illustrated in FIG. 9B, the light receiver 10 that is formed in advance and has the wiring layer 20 provided thereon is bonded with the wiring layer 20 and the light receiver 70 being disposed to face each other. Subsequently, as illustrated in FIG. 9C, the support substrate 83 is removed, and further an opening that passes through the silicon substrate 71 to avoid the black silicon region (photoelectric converter 72) and reaches the wiring 23 is formed. After that, an oxide film (not illustrated) is formed in the opening, and the oxide film at an opening bottom portion is etched back. Then, the through wiring 33 is formed. Next, as illustrated in FIG. 9D, the interlayer insulating layer 41 is further formed on the surface of the wiring layer 40, and the one or the plurality of pad portions 43 is embedded in its surface.

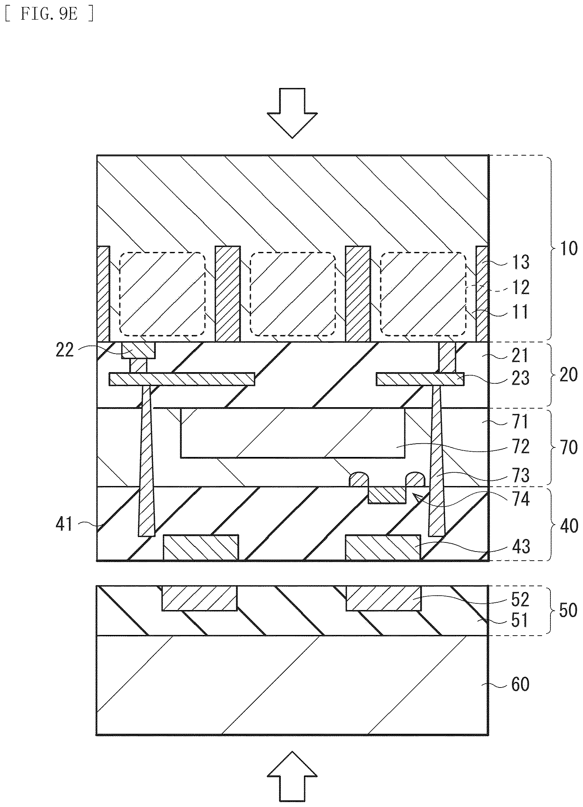

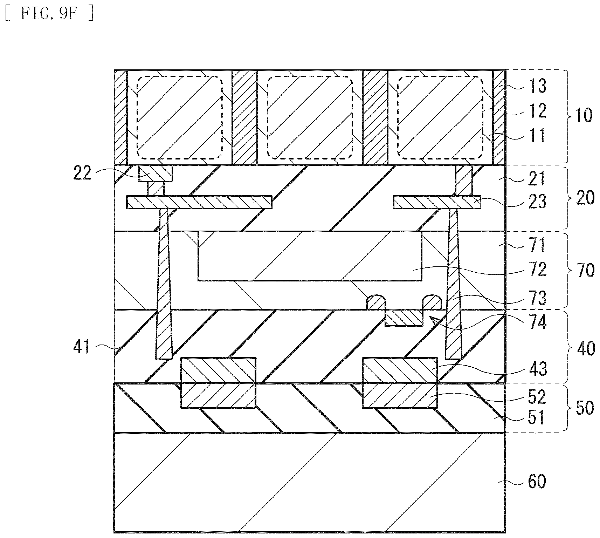

Subsequently, as illustrated in FIG. 9E, the wiring layer 50 of the logic substrate 60B formed in advance and the wiring layer 40 are disposed to face each other to allow the pad portions 43 and 52 to be joined and bonded to each other. Next, as illustrated in FIG. 9F, the silicon substrate 11 of the light receiver 10 is thinned to a predetermined thickness and flattened by, for example, CMP. After that, the color filter 14 and the on-chip lens 15 are formed in order on the first surface 1151 side on the silicon substrate 11. In this manner, the optical detection unit 4 illustrated in FIG. 8 is completed.

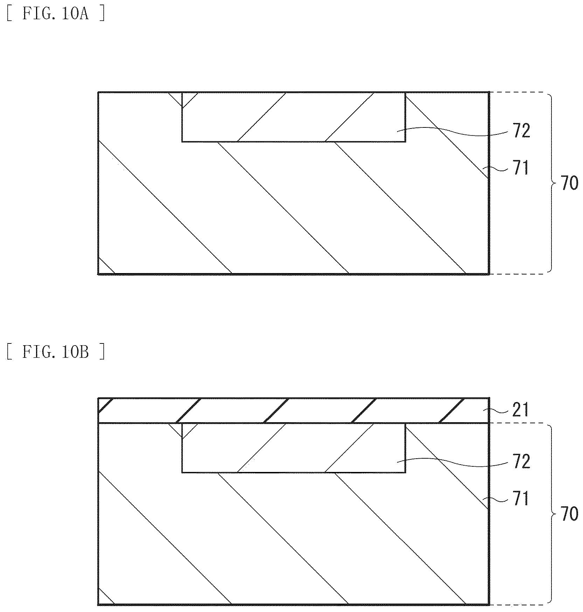

FIG. 10A to FIG. 10G are another example of the method of manufacturing the optical detection unit 4 in order of process.

First, as illustrated in FIG. 10A, a black silicon region is formed in the silicon substrate 71 by using, for example, dry etching or a laser. After that, for example, ion implantation is performed to control p-type or n-type impurity concentration to provide the photoelectric converter 72, and thus the light receiver 70 is formed. Next, as illustrated in FIG. 10B, the interlayer insulating layer 21 including a pinning film is formed on the surface 71S1 of the silicon substrate 71 having the photoelectric converter 72 provided therein.

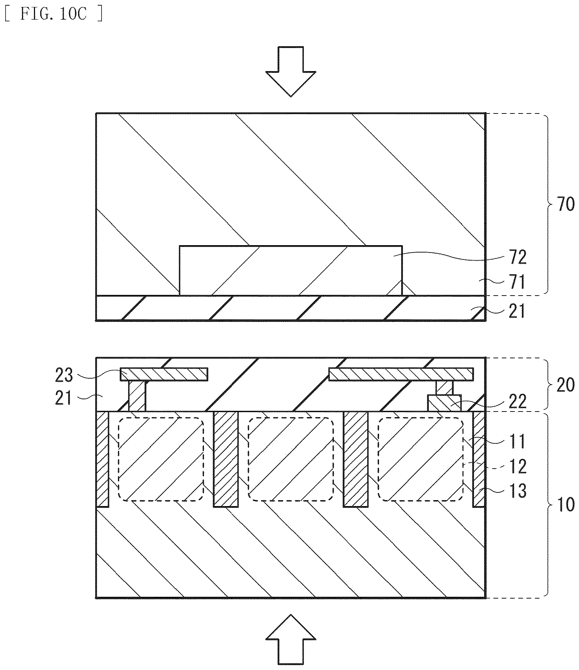

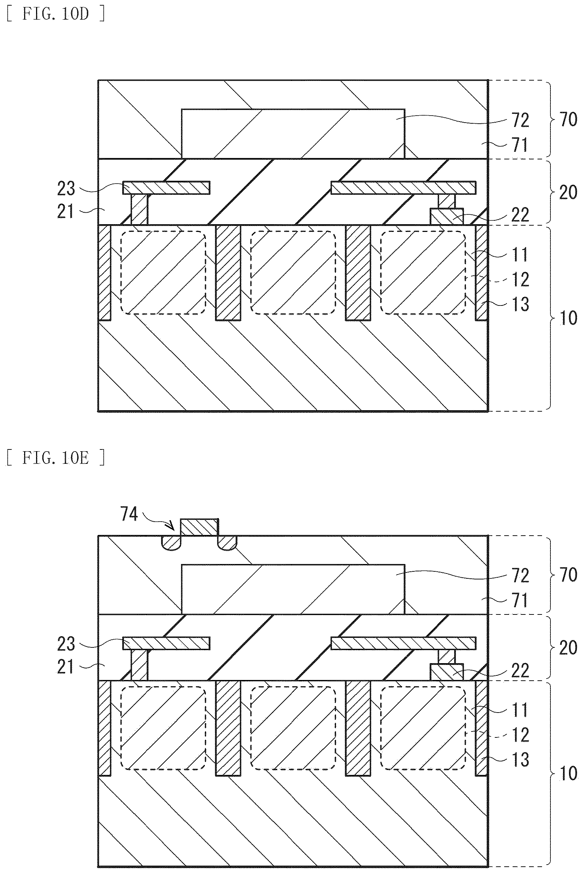

Subsequently, as illustrated in FIG. 10C, the light receiver 10 that is formed in advance and has the wiring layer 20 provided thereon is bonded with the wiring layer 20 and the interlayer insulating layer 21 provided on the light receiver 70 being disposed to face each other. Next, as illustrated in FIG. 10D, the silicon substrate 71 is thinned to a predetermined thickness by, for example, CMP. After that, as illustrated in FIG. 10E, the pixel transistor 74 is formed on the surface 71S2 of the silicon substrate.

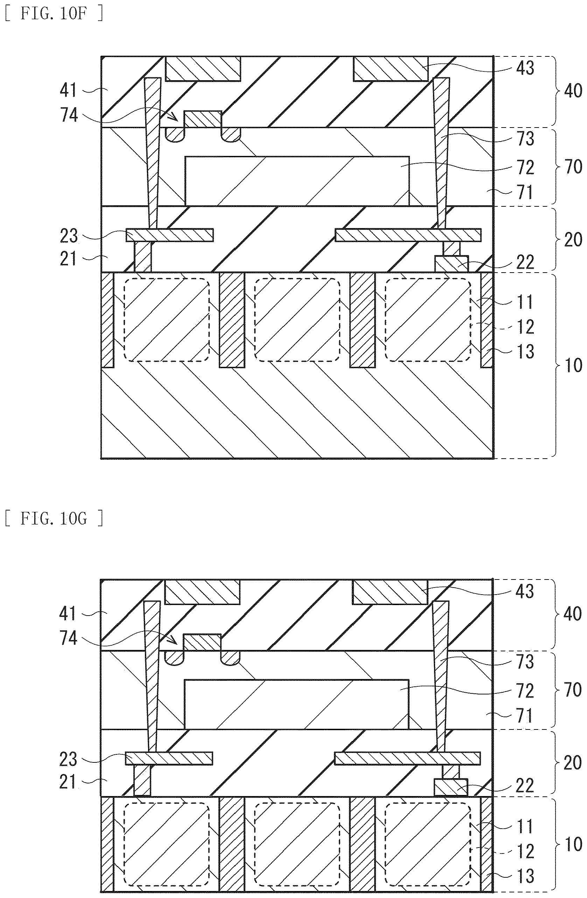

Subsequently, as illustrated in FIG. 10F, the through wiring 33 that passes through the silicon substrate 71 to reach the wiring 23 and the wiring layer 40 having the one or the plurality of pad portions 43 exposed to its surface are formed. Next, as illustrated in FIG. 10G, the silicon substrate 11 of the light receiver 10 is thinned to a predetermined thickness by, for example, CMP. After that, the color filter 14 and the on-chip lens 15 are formed in order on the first surface 11S1 side on the silicon substrate 11. In this manner, the optical detection unit 4 illustrated in FIG. 8 is completed. In this manufacturing method, although a thermal load is applied to the light receiver 10 in which the red pixel Pr, the green pixel Pg, and the blue pixel Pb have been provided, it is possible to manufacture the optical detection unit easier as compared with the above-described manufacturing method.

As described above, in this modification example, the photoelectric converter (photoelectric converter 72) that photoelectrically converts a wavelength component in the near-infrared region is formed in black silicon. This makes it possible to form the pixel transistor 74 in the light receiver 70.

It is to be noted that this modification example shows an example in which black silicon is embedded in the silicon substrate 71, but this silicon substrate 71 may be replaced with black silicon. Further, similarly to the above-described embodiment, the photoelectric converter 72 may be embedded and formed in an insulating film, or only a part of the silicon substrate 71 may be left and the peripheries of the photoelectric converter 72 and the silicon substrate 71 may be embedded with an insulating film.

### <3. Application Examples>

### [Application Example 1]

FIG. 11 illustrates an example of an overall configuration of the optical detection unit (for example, the optical detection unit 1) illustrated in FIG. 1 and other figures.

The optical detection unit 1 is, for example, a CMOS image sensor, and takes in incident light (image light) from an object via an optical lens system (not illustrated) and converts an amount of incident light formed as an image on an imaging plane into an electric signal in a unit of pixel to output the electric signal as a pixel signal. The optical detection unit 1 includes the pixel section 100A serving as an imaging area on the silicon substrate 11, and includes, in a peripheral region of this pixel section 100A, for example, a vertical drive circuit 111, a column signal processing circuit 112, a horizontal drive circuit 113, an output circuit 114, a control circuit 115, and an input/output terminal 116.

The pixel section 100A includes, for example, a plurality of unit pixels P two-dimensionally disposed in a matrix pattern. To those unit pixels P, for example, a pixel drive line Lread (specifically, row selection line and reset control line) is wired for each pixel row, and a vertical signal line Lsig is wired for each pixel column. The pixel drive line Lread transmits a drive signal for use in reading out a signal from a pixel. One end of the pixel drive line Lread is connected to an output end corresponding to each row of the vertical drive circuit 111.

The vertical drive circuit 111 is a pixel driver that includes, for example, a shift register and an address decoder and drives each unit pixel P of the pixel section 100A in, for example, a unit of row. A signal output from each unit pixel P of the pixel row selected and scanned by the vertical drive circuit 111 is supplied to the column signal processing circuit 112 through each of the vertical signal lines Lsig. The column signal processing circuit 112 includes, for example, an amplifier and a horizontal selection switch provided for each vertical signal line Lsig.

The horizontal drive circuit 113 includes, for example, a shift register and an address decoder, and scans and drives in order each horizontal selection switch of the column signal processing circuit 112. Through this selection and scanning performed by the horizontal drive circuit 113, a signal of each pixel transmitted through each of the vertical signal lines Lsig is output to a horizontal signal line 121 in order, and the signal is transmitted to the outside of the silicon substrate 11 through this horizontal signal line 121.

The output circuit 114 performs signal processing on the signal sequentially supplied from each column signal processing circuit 112 via the horizontal signal line 121 to output the processed signal. In some cases, the output circuit 114 performs, for example, only buffering, and in other cases, the output circuit 114 performs black level adjustment, column fluctuation correction, and various types of digital signal processing.

A circuit part including the vertical drive circuit 111, the column signal processing circuit 112, the horizontal drive circuit 113, the horizontal signal line 121, and the output circuit 114 may be formed directly on the silicon substrate 11, or may be disposed on an external control IC. Further, the circuit part including those circuits may be formed on another substrate coupled by a cable or others.

The control circuit 115 receives, for example, a clock given from the outside of the silicon substrate 11 and data giving an instruction of the operation mode, and outputs data such as internal information of the optical detection unit 1. The control circuit 115 further includes a timing generator that generates various timing signals, and drives and controls peripheral circuits such as the vertical drive circuit 111, the column signal processing circuit 112, and the horizontal drive circuit 113 on the basis of the various timing signals generated in this timing generator.

The input/output terminal 116 exchanges signals with the outside.

### [Application Example 2]

Further, it is possible to apply the optical detection unit 1 as described above to, for example, various electronic apparatus such as imaging systems including a digital still camera, a digital video camera, and the like, a mobile phone having an imaging function, or other apparatus including an imaging function.

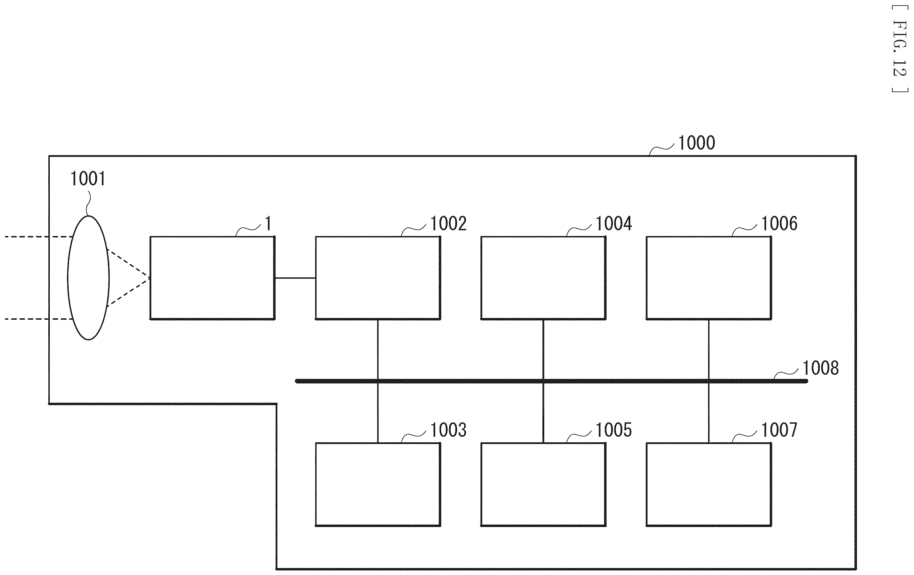

FIG. 12 is a block diagram illustrating an example of a configuration of an electronic apparatus 1000.

As illustrated in FIG. 12, the electronic apparatus 1000 includes an optical system 1001, an optical detection unit 1, and a DSP (Digital Signal Processor) 1002, and is coupled via a bus 1008 to the DSP 1002, a memory 1003, a display unit 1004, a storage unit 1005, an operation system 1006, and a power system 1007. It is possible for the electronic apparatus 1000 to capture a still image and a moving image.

The optical system 1001 includes one or a plurality of lenses, and takes in incident light (image light) from an object to form an image of the incident light (image light) on the imaging plane of the optical detection unit 1.

As the optical detection unit 1, the above-described optical detection unit 1 is applied. The optical detection unit 1 converts the amount of incident light formed as an image on the imaging plane by the optical system 1001 into an electric signal in a unit of pixel to supply the electric signal as a pixel signal to the DSP 1002.

The DSP 1002 performs various types of signal processing on the signal from the optical detection unit 1 to acquire an image, and causes the memory 1003 to temporarily store data of this image. The data of the image stored in the memory 1003 is recorded in the storage unit 1005 or is supplied to the display unit 1004 to display the image. Further, the operation system 1006 receives various operations performed by the user and supplies an operation signal to each block of the electronic apparatus 1000, and the power system 1007 supplies power required for driving each block of the electronic apparatus 1000.

### [Application Example 3]

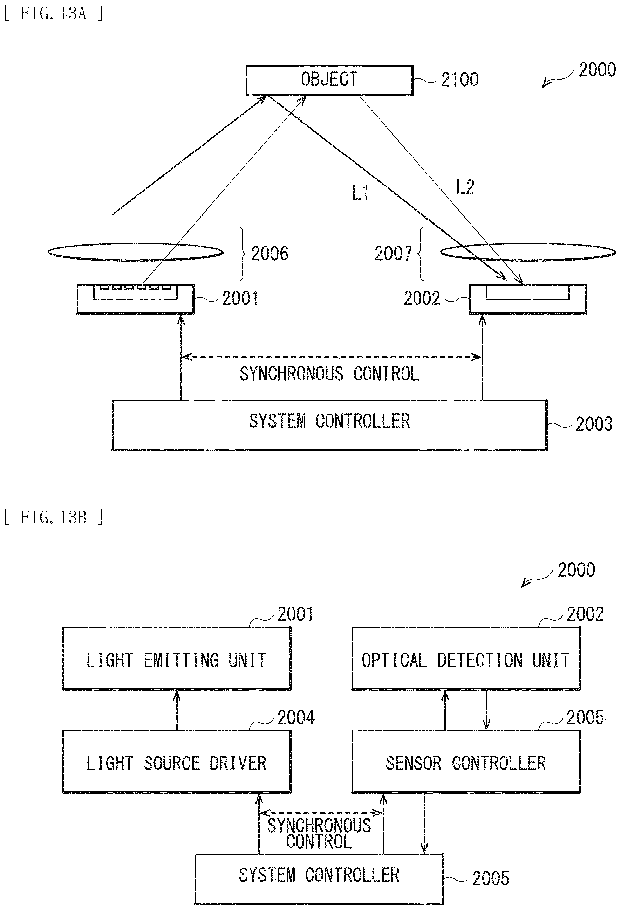

FIG. 13A schematically illustrates an example of an overall configuration of an optical detection system 2000 including the optical detection unit 1. FIG. 13B illustrates an example of a circuit configuration of the optical detection system 2000. The optical detection system 2000 includes a light emitting unit 2001 serving as a light source that emits infrared light L2, and an optical detection unit 2002 serving as a light receiver including a photoelectric conversion device. As the optical detection unit 2002, it is possible to use the above-described optical detection unit 1. The optical detection system 2000 may further include a system controller 2003, a light source driver 2004, a sensor controller 2005, a light source-side optical system 2006, and a camera-side optical system 2007.

It is possible for the optical detection unit 2002 to detect light L1 and light L2. The light L1 is light being ambient light from the outside reflected by an object (measurement target) 2100 (FIG. 13A). The light L2 is light emitted by the light emitting unit 2001 and then reflected by the object 2100. The light L1 is, for example, visible light, and the light L2 is, for example, infrared light. It is possible to detect the light L1 by the photoelectric converter in the optical detection unit 2002, and it is possible to detect the light L2 in a photoelectric conversion region in the optical detection unit 2002. It is possible to obtain image information regarding the object 2100 from the light L1, and it is possible to obtain information regarding the distance between the object 2100 and the optical detection system 2000 from the light L2. It is possible to mount the optical detection system 2000 on, for example, an electronic apparatus such as a smartphone or a moving body such as a vehicle. It is possible to configure the light emitting unit 2001 of, for example, a semiconductor laser, a surface emitting semiconductor laser, or a vertical cavity surface emitting laser (VCSEL). As a method of detecting the light L2 emitted from the light emitting unit 2001 by the optical detection unit 2002, it is possible to adopt, for example, an iTOF method, but the detection method is not limited thereto. In the iTOF method, it is possible for the photoelectric converter to measure a distance with respect to the object 2100 by, for example, a Time-of-Flight (TOF). As the method of detecting the light L2 emitted from the light emitting unit 2001 by the optical detection unit 2002, it is also possible to adopt, for example, a structured light method or a stereovision method. For example, in the structured light method, light having a pattern determined in advance is projected onto the object 2100, and a distortion level of this pattern is analyzed. This makes it possible to measure the distance between the optical detection system 2000 and the object 2100. Further, in the stereovision method, for example, two or more cameras are used to acquire two or more images obtained by viewing the object 2100 from two or more different viewpoints. This makes it possible to measure the distance between the optical detection system 2000 and the object. It is to be noted that it is possible to control the light emitting unit 2001 and the optical detection unit 2002 in synchronization by the system controller 2003.

### <4. Usage Examples>

### [Usage Example to Endoscopic Surgery System]

It is possible to utilize the technique according to the present disclosure (present technique) for various products. For example, the technique according to the present disclosure may be applied to an endoscopic surgery system.

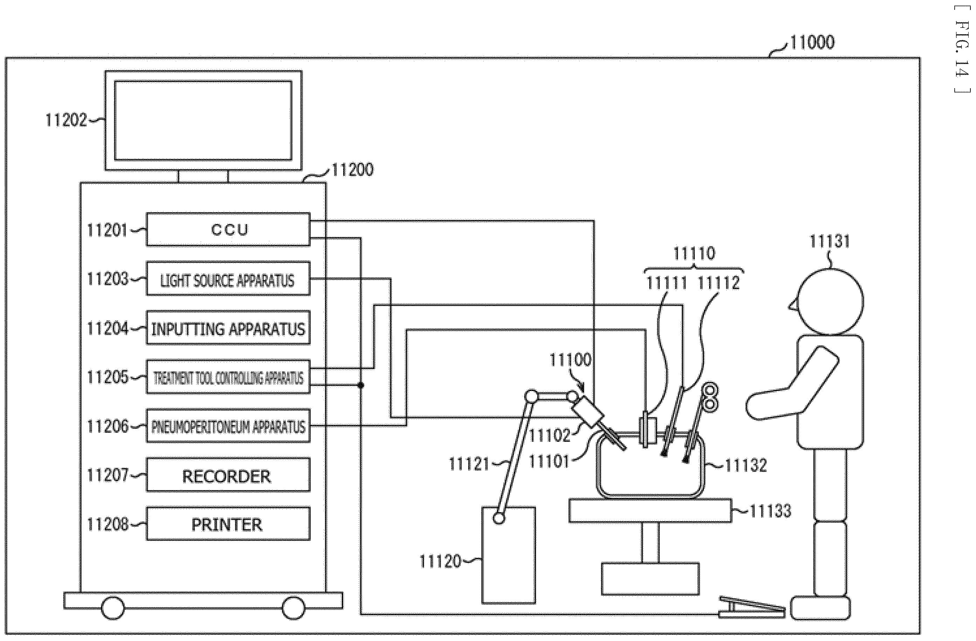

FIG. 14 is a view depicting an example of a schematic configuration of an endoscopic surgery system to which the technology according to an embodiment of the present disclosure (present technology) can be applied.

In FIG. 14, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photoelectrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

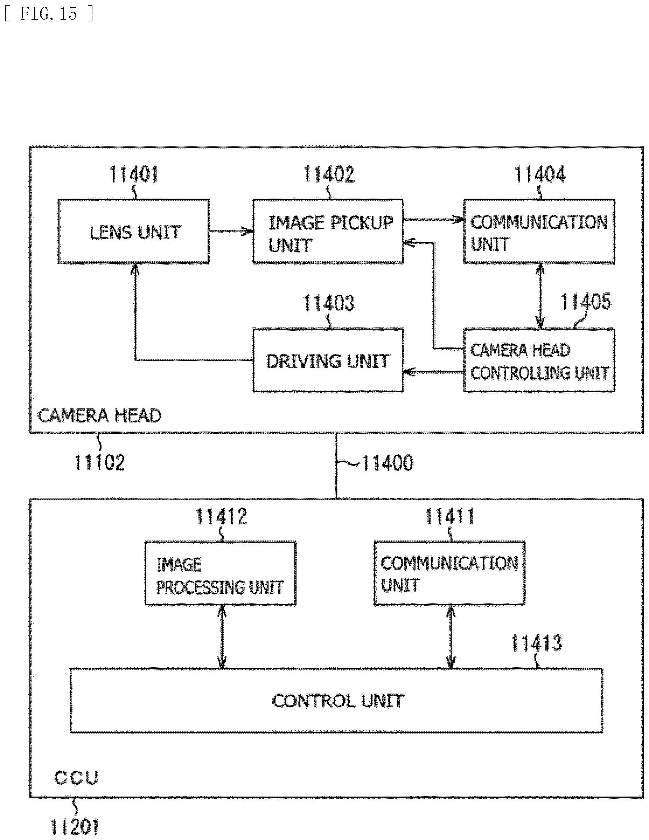

FIG. 15 is a block diagram depicting an example of a functional configuration of the camera head 11102 and the CCU 11201 depicted in FIG. 14.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

Description has been given above of an example of the endoscopic surgery system to which the technique according to the present disclosure may be applied. The technique according to the present disclosure may be applied to the image pickup unit 11402 among the configurations described above. With the technique according to the present disclosure being applied to the image pickup unit 11402, the detection accuracy is improved.

It is to be noted that description has been given here of the endoscopic surgery system as an example, but the technique according to the present disclosure may be applied to other systems, for example, a microsurgery system.

### [Usage Example to Moving Body]

It is possible to utilize the technique according to the present disclosure for various products. For example, the technique according to the present disclosure may be implemented as an apparatus to be mounted on a moving body of any type, such as an automobile, an electric vehicle, a hybrid electric vehicle, a motorcycle, a bicycle, a personal mobility, an airplane, a drone, a ship, a robot, construction equipment, or farm equipment (tractor).

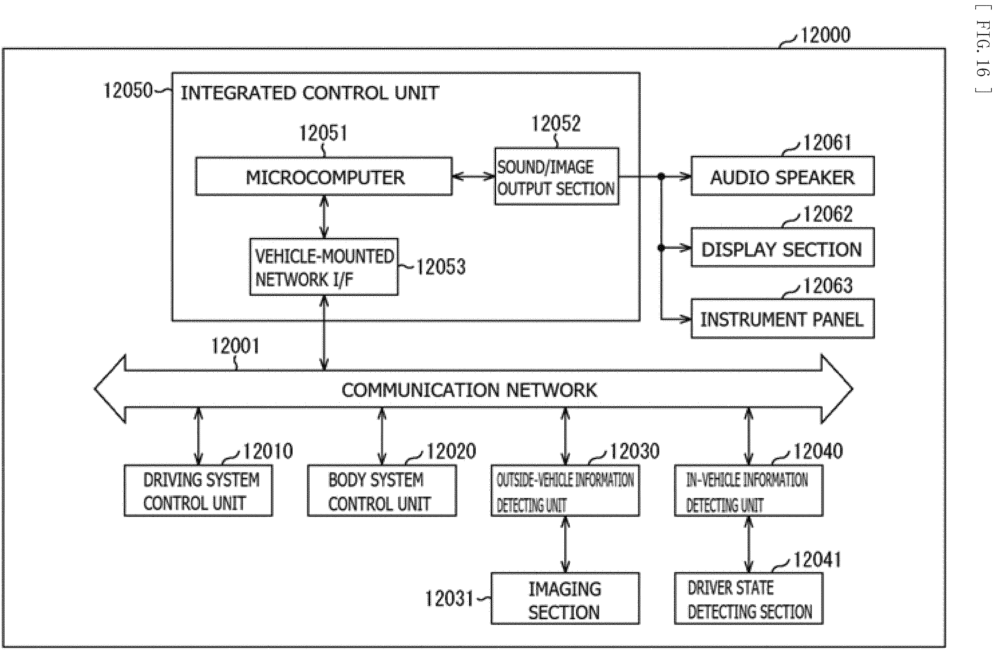

FIG. 16 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 16, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 16, an audio speaker 12061, a display section 12062, and an instrument panel 12063 are illustrated as the output device. The display section 12062 may, for example, include at least one of an on-board display and a head-up display.

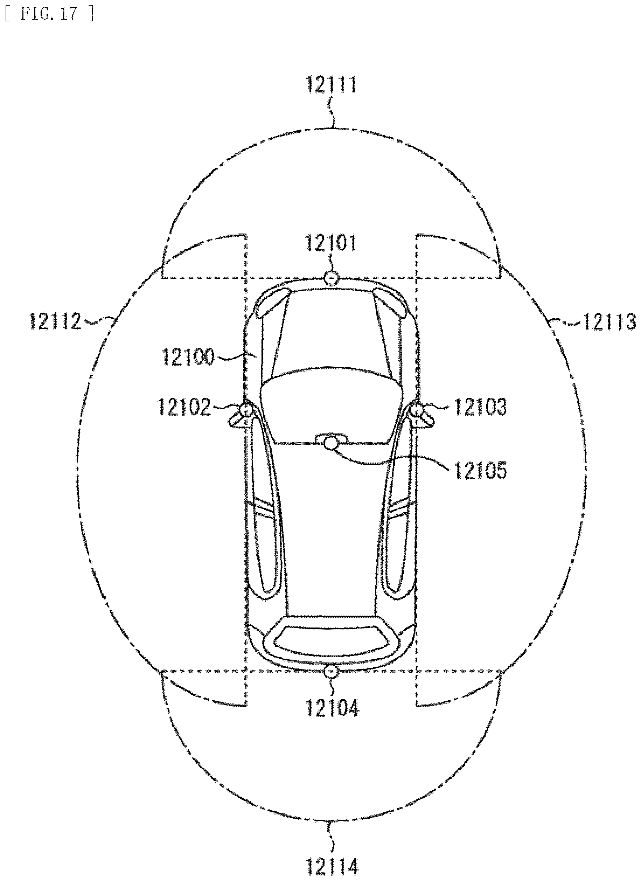

FIG. 17 is a diagram depicting an example of the installation position of the imaging section 12031.

In FIG. 17, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 17 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

Description has been given above of an example of the moving body control system to which the technique according to the present disclosure may be applied. The technique according to the present disclosure may be applied to the imaging section 12031 among the configurations described above. Specifically, it is possible to apply the optical detection unit (for example, the optical detection unit 1) according to each of the above-described embodiment and the modification examples thereof to the imaging section 12031. With the technique according to the present disclosure being applied to the imaging section 12031, it is possible to obtain a high-definition captured image having less noise, and hence it is possible to perform highly accurate control using the captured image in the moving body control system.

The present disclosure has been described above by means of the embodiment, Modification Examples 1 to 3, Application Examples, and Usage Examples. However, the present disclosure is not limited to the above-described embodiment and others, and various modifications may be made thereto. For example, the above-described embodiment shows an example in which the readout circuit that generates a pixel signal on the basis of signal charges generated through photoelectric conversion in the photoelectric converter 12 of each of the red pixel Pr, the green pixel Pg, and the blue pixel Pb is provided on the circuit board 60, but each transistor included in those readout circuits may be provided on the second surface 11S2 of the silicon substrate 11.

Further, the above-described embodiment and others show an example in which a chip in which the light receiver 10 and the light receiver 30 are formed and a chip in which the circuit board 60 for the readout circuit, the logic circuit, or other circuits is formed have the same size as each other, but the present disclosure is not limited thereto. For example, the chip in which the circuit board 60 is formed may be larger than the chip in which the light receiver 10 and the light receiver 30 are formed.

It is to be noted that the effects described herein are merely examples, and are not limited to their descriptions and may be other effects.

It is to be noted that the present disclosure may take the following configurations. According to the present technique having the following configuration, the first photoelectric converter photoelectrically converts a wavelength component in the visible light region, the second photoelectric converter photoelectrically converts a wavelength component in the near-infrared region, and the one or a plurality of wirings included in the first wiring layer provided between the first photoelectric converter and the second photoelectric converter that are stacked on each other is formed with use of a material that transmits a wavelength component in a longer wavelength region than the visible light region. This configuration reduces reduction of incident light entering the second photoelectric converter. It is thus possible to improve the image quality in each of the visible light region and the near-infrared region.
(1) An optical detection unit including:
   a first photoelectric converter that photoelectrically converts a wavelength component in a visible light region;
   a second photoelectric converter that photoelectrically converts a wavelength component in a near-infrared region, the second photoelectric converter being stacked on the first photoelectric converter; and
   a first wiring layer provided between the first photoelectric converter and the second photoelectric converter, the first wiring layer including one or a plurality of wirings formed with use of a material that transmits a wavelength component in a longer wavelength region than the visible light region, the one or the plurality of wirings being used for reading out charges generated through photoelectric conversion in the first photoelectric converter.
(2) The optical detection unit according to (1), in which the one or the plurality of wirings is formed with use of polysilicon.
(3) The optical detection unit according to (1) or (2), in which the first photoelectric converter is provided in a first semiconductor substrate having a first surface serving as a light incident surface and a second surface on a side opposite to the first surface.
(4) The optical detection unit according to (3), in which
   the first semiconductor substrate has a plurality of pixels disposed in an array pattern, each of the plurality of pixels being configured to photoelectrically convert a corresponding one of a wavelength component in a red range, a wavelength component in a green range, and a wavelength component in a blue range, and
   the first photoelectric converter is embedded and formed in the first semiconductor substrate for each of the plurality of pixels.
(5) The optical detection unit according to (3) or (4), in which
   the second photoelectric converter is embedded and formed in a second semiconductor substrate having a third surface and a fourth surface on a side opposite to the third surface, and
   the second semiconductor substrate is disposed to allow the third surface to be opposed to the second surface of the first semiconductor substrate through intermediation of the first wiring layer.
(6) The optical detection unit according to (5), further including a circuit board disposed on the fourth surface side of the second semiconductor substrate, the circuit board having one or a plurality of readout circuits and a logic circuit, the one or the plurality of readout circuits being configured to generate a pixel signal on the basis of charges generated through photoelectric conversion in each of the first photoelectric converter and the second photoelectric converter, the logic circuit being configured to process the pixel signal.
(7) The optical detection unit according to (5) or (6), further including a first circuit board and a second circuit board, the first circuit board having one or a plurality of readout circuits that generates a pixel signal on the basis of charges generated through photoelectric conversion in each of the first photoelectric converter and the second photoelectric converter, the second circuit board having a logic circuit that processes the pixel signal, in which
   the first circuit board and the second circuit board are stacked on the fourth surface side of the second semiconductor substrate in a stated order.
(8) The optical detection unit according to (6) or (7), further including one or a plurality of through wirings that passes between the third surface and the fourth surface of the second semiconductor substrate, in which
   the one or the plurality of wiring layers and the one or the plurality of readout circuits are electrically coupled to each other via the one or the plurality of through wirings.
(9) The optical detection unit according to (8), in which the one or the plurality of through wirings is provided around the second photoelectric converter.
(10) The optical detection unit according to any one of (1) to (9), in which, as the second photoelectric converter, one second photoelectric converter is provided for each of a plurality of the first photoelectric converters.
(11) The optical detection unit according to any one of (1) to (10), in which, as the second photoelectric converter, one second photoelectric converter is provided for every four first photoelectric converters serving as the first photoelectric converter disposed in 2 rows by 2 columns.
(12) The optical detection unit according to (11), in which, in plan view, an intersection of the four first photoelectric converters disposed in 2 rows by 2 columns and a center of the second photoelectric converter match each other.
(13) The optical detection unit according to any one of (1) to (12), further including, between the first photoelectric converter and the second photoelectric converter, a pass filter that selectively transmits a wavelength component in the near-infrared region.
(14) The optical detection unit according to any one of (3) to (13), in which the first semiconductor substrate includes a silicon substrate.
(15) The optical detection unit according to any one of (5) to (14), in which the second semiconductor substrate includes a substrate containing germanium, silicon germanium, indium-gallium-arsenic, or black silicon.
(16) An electronic apparatus including an optical detection unit, the optical detection unit including:
   a first photoelectric converter that photoelectrically converts a wavelength component in a visible light region;
   a second photoelectric converter that photoelectrically converts a wavelength component in a near-infrared region, the second photoelectric converter being stacked on the first photoelectric converter; and
   a first wiring layer provided between the first photoelectric converter and the second photoelectric converter, the first wiring layer including one or a plurality of wirings formed with use of a material that transmits a wavelength component in a longer wavelength region than the visible light region, the one or the plurality of wirings being used for reading out charges generated through photoelectric conversion in the first photoelectric converter.
(17) An optical detection system including:
   a light source that emits near-infrared light; and
   an optical detection unit that detects ambient light and the near-infrared light that are reflected by an object, in which
   the optical detection unit includes:
      a first photoelectric converter that photoelectrically converts a wavelength component in a visible light region;
      a second photoelectric converter that photoelectrically converts a wavelength component in a near-infrared region, the second photoelectric converter being stacked on the first photoelectric converter; and
      a first wiring layer provided between the first photoelectric converter and the second photoelectric converter, the first wiring layer including one or a plurality of wirings formed with use of a material that transmits a wavelength component in a longer wavelength region than the visible light region, the one or the plurality of wirings being used for reading out charges generated through photoelectric conversion in the first photoelectric converter.

The present application claims the benefit of US Provisional Patent Application No. 63/318117 filed with the United States Patent and Trademark Office on March 9, 2022, the entire contents of which are incorporated herein by reference.

It should be understood by those skilled in the art that various modifications, combinations, sub-combinations and alterations may occur depending on design requirements and other factors insofar as they are within the scope of the appended claims or the equivalents thereof.

## Claims

1. An optical detection unit comprising:
a first photoelectric converter that photoelectrically converts a wavelength component in a visible light region;
a second photoelectric converter that photoelectrically converts a wavelength component in a near-infrared region, the second photoelectric converter being stacked on the first photoelectric converter; and
a first wiring layer provided between the first photoelectric converter and the second photoelectric converter, the first wiring layer including one or a plurality of wirings formed with use of a material that transmits a wavelength component in a longer wavelength region than the visible light region, the one or the plurality of wirings being used for reading out charges generated through photoelectric conversion in the first photoelectric converter.

2. The optical detection unit according to claim 1, wherein the one or the plurality of wirings is formed with use of polysilicon.

3. The optical detection unit according to claim 1, wherein the first photoelectric converter is provided in a first semiconductor substrate having a first surface serving as a light incident surface and a second surface on a side opposite to the first surface.

4. The optical detection unit according to claim 3, wherein
the first semiconductor substrate has a plurality of pixels disposed in an array pattern, each of the plurality of pixels being configured to photoelectrically convert a corresponding one of a wavelength component in a red range, a wavelength component in a green range, and a wavelength component in a blue range, and
the first photoelectric converter is embedded and formed in the first semiconductor substrate for each of the plurality of pixels.

5. The optical detection unit according to claim 3, wherein
the second photoelectric converter is embedded and formed in a second semiconductor substrate having a third surface and a fourth surface on a side opposite to the third surface, and
the second semiconductor substrate is disposed to allow the third surface to be opposed to the second surface of the first semiconductor substrate through intermediation of the first wiring layer.

6. The optical detection unit according to claim 5, further comprising a circuit board disposed on the fourth surface side of the second semiconductor substrate, the circuit board having one or a plurality of readout circuits and a logic circuit, the one or the plurality of readout circuits being configured to generate a pixel signal on a basis of charges generated through photoelectric conversion in each of the first photoelectric converter and the second photoelectric converter, the logic circuit being configured to process the pixel signal.

7. The optical detection unit according to claim 5, further comprising a first circuit board and a second circuit board, the first circuit board having one or a plurality of readout circuits that generates a pixel signal on a basis of charges generated through photoelectric conversion in each of the first photoelectric converter and the second photoelectric converter, the second circuit board having a logic circuit that processes the pixel signal, wherein
the first circuit board and the second circuit board are stacked on the fourth surface side of the second semiconductor substrate in a stated order.

8. The optical detection unit according to claim 6, further comprising one or a plurality of through wirings that passes between the third surface and the fourth surface of the second semiconductor substrate, wherein
the one or the plurality of wiring layers and the one or the plurality of readout circuits are electrically coupled to each other via the one or the plurality of through wirings.

9. The optical detection unit according to claim 8, wherein the one or the plurality of through wirings is provided around the second photoelectric converter.

10. The optical detection unit according to claim 1, wherein, as the second photoelectric converter, one second photoelectric converter is provided for each of a plurality of the first photoelectric converters.

11. The optical detection unit according to claim 1, wherein, as the second photoelectric converter, one second photoelectric converter is provided for every four first photoelectric converters serving as the first photoelectric converter disposed in 2 rows by 2 columns.

12. The optical detection unit according to claim 11, wherein, in plan view, an intersection of the four first photoelectric converters disposed in 2 rows by 2 columns and a center of the second photoelectric converter match each other.

13. The optical detection unit according claim 1, further comprising, between the first photoelectric converter and the second photoelectric converter, a pass filter that selectively transmits a wavelength component in the near-infrared region.

14. The optical detection unit according to claim 3, wherein the first semiconductor substrate comprises a silicon substrate.

15. The optical detection unit according to claim 5, wherein the second semiconductor substrate comprises a substrate containing germanium, silicon germanium, indium-gallium-arsenic, or black silicon.

16. An electronic apparatus including an optical detection unit, the optical detection unit comprising:
a first photoelectric converter that photoelectrically converts a wavelength component in a visible light region;
a second photoelectric converter that photoelectrically converts a wavelength component in a near-infrared region, the second photoelectric converter being stacked on the first photoelectric converter; and
a first wiring layer provided between the first photoelectric converter and the second photoelectric converter, the first wiring layer including one or a plurality of wirings formed with use of a material that transmits a wavelength component in a longer wavelength region than the visible light region, the one or the plurality of wirings being used for reading out charges generated through photoelectric conversion in the first photoelectric converter.

17. An optical detection system comprising:
a light source that emits near-infrared light; and
an optical detection unit that detects ambient light and the near-infrared light that are reflected by an object, wherein
the optical detection unit includes:
a first photoelectric converter that photoelectrically converts a wavelength component in a visible light region;
a second photoelectric converter that photoelectrically converts a wavelength component in a near-infrared region, the second photoelectric converter being stacked on the first photoelectric converter; and
a first wiring layer provided between the first photoelectric converter and the second photoelectric converter, the first wiring layer including one or a plurality of wirings formed with use of a material that transmits a wavelength component in a longer wavelength region than the visible light region, the one or the plurality of wirings being used for reading out charges generated through photoelectric conversion in the first photoelectric converter.
